# EUROPÄISCHE PATENTANMELDUNG

(11) **EP 4 529 375 A1**
(43) Veröffentlichungstag der Anmeldung: **26.03.2025**
(21) Anmeldenummer: 23198597.9
(22) Anmeldetag: 20.09.2023
(51) Int. Cl.: H05K 7/20, H02M 7/00

(54) **ANORDNUNG FÜR KÜHLKÖRPER BEI EINEM MULTILEVELUMRICHTER**

(71) Anmelder: Siemens Aktiengesellschaft, 80333 München (DE)
(72) Erfinder: Hartwig, Raphael, 92342 Freystadt (DE); Kiesel, Alexander, 82467 Garmisch-Partenkirchen (DE)
(74) Vertreter: Siemens Patent Attorneys

(57) **Zusammenfassung**

Ein Umrichter weist eine Mehrzahl von Phasensträngen (1) auf, die jeweils zwei Gleichspannungsanschlüsse (2, 3), einen Wechselspannungsanschluss (4) und zwischen dem Wechselspannungsanschluss (4) und den Gleichspannungsanschlüssen (2, 3) jeweils eine Reihenschaltung von jeweils mehreren Halbleiterschaltern (8) aufweisen. Die Phasenstränge (1) weisen weiterhin Kondensatoren (9) auf, die jeweils mit zwei Knotenpunkten (10) zwischen zwei Halbleiterschaltern (8) des jeweiligen Phasenstrangs (1) verbunden sind. Vom Wechselspannungsanschluss (4) zum jeweiligen Gleichspannungsanschluss (2, 3) gesehen ist die Anzahl an Halbleiterschaltern (8) zwischen dem jeweiligen Knotenpunkt (10) und dem jeweiligen Gleichspannungsanschluss (2, 3) gleich groß. Den Halbleiterschaltern (8) ist jeweils ein eigener Kühlkörper (11) zugeordnet, der eine an dem jeweiligen Halbleiterschalter (8) direkt anliegende Kontaktfläche (12) aufweist und mittels dessen der jeweilige Halbleiterschalter (8) gekühlt wird. Der jeweilige Kühlkörper (11) ist in einem aus einem Isoliermaterial bestehenden Gehäuse (13) angeordnet, durch das der jeweilige Kühlkörper (11) von den anderen Kühlkörpern (11) mechanisch und elektrisch getrennt ist.

## Beschreibung

Die vorliegende Erfindung geht aus von einem Umrichter,
- wobei der Umrichter eine Mehrzahl von Phasensträngen aufweist,
- wobei die Phasenstränge jeweils zwei Gleichspannungsanschlüsse und einen Wechselspannungsanschluss aufweisen,
- wobei die Phasenstränge zwischen dem Wechselspannungsanschluss und den Gleichspannungsanschlüssen jeweils eine Reihenschaltung von jeweils mehreren Halbleiterschaltern aufweisen,
- wobei die Phasenstränge Kondensatoren aufweisen, die jeweils mit zwei Knotenpunkten zwischen zwei Halbleiterschaltern des jeweiligen Phasenstrangs verbunden sind,
- wobei vom Wechselspannungsanschluss zum jeweiligen Gleichspannungsanschluss gesehen die Anzahl an Halbleiterschaltern zwischen dem jeweiligen Knotenpunkt und dem jeweiligen Gleichspannungsanschluss gleich groß ist.

Ein derartiger Umrichter ist allgemein bekannt.

In üblichen Zweilevel- und Dreilevel-Umrichtertopologien ist ein erheblicher Filteraufwand erforderlich. Hiermit verbunden sind das für den Filter erforderliche Volumen und die für den Filter erforderlichen Kosten hoch. Die sogenannte Flying-Capacitor-Multileveltopologie bietet demgegenüber nennenswerte Vorteile.

Die entsprechende Topologie als solche ist Fachleuten bekannt. Rein beispielhaft kann auf die beiden Fachaufsätze "Behaviour of the flying capacitor converter under critical operating conditions" von P. Papamanolis, D.Neumayr und J.W. Kolar, 2017 IEEE 26 International Symposium on Industrial Electronics (ISIE), Edinburgh, UK, 2017, Seiten 628 bis 635, und "Analysis and Design of Multicell DC/DC Converters Using Vectorized Models" von Meynard, Thierry A. (2015) verwiesen werden.

Umrichter im industriellen Umfeld - dies gilt gleichermaßen für Zweilevel-, Dreilevel- und Multilevel-Umrichter - müssen typischerweise kurzfristig Überlasten zulassen. Das thermische System des jeweiligen Umrichters muss daher derart dimensioniert sein, dass die Halbleiterschalter die während derartiger Überlastzeiten generierte Verlustleistung schnell genug abführen können. Hierfür sind Kühlkörper erforderlich.

Der Kühlkörper erfüllt im wesentlichen zwei Funktionen. Zum einen weist er eine Pufferfunktion auf, dass er also während der kurzzeitigen Überlast die Verlustleistung aufnehmen und später an die Umgebung abgeben kann. Zum anderen muss er auch die im Dauerbetrieb auftretende (gegenüber der Verlustleistung bei Überlast geringere) Verlustleistung aufnehmen und an die Umgebung abgeben können.

Bei der Flying-Capacitor-Multileveltopologie sind üblicherweise erheblich mehr Halbleiterschalter vorhanden als bei Zweilevel- und Dreilevel-Umrichtertopologien. Die einzelnen Halbleiterschalter können daher kleiner dimensioniert werden, oftmals sogar als einzelne oberflächenmontierte Bauteile (SMD - surface mounted device) ausgebildet sein. Insbesondere oberflächenmontierte Bauteile weisen jedoch sehr geringe thermische Massen auf, so dass ihre eigene, intrinsische Überlastfähigkeit begrenzt ist. Sie müssen daher sehr gut an einen Kühlkörper angebunden sein, um eine nennenswerte Überlastfähigkeit aufweisen zu können.

Im Stand der Technik ist es bei Zweilevel- und Dreilevel-Umrichtern üblich, die Halbleiterschalter auf einem Substrat anzuordnen. Das Substrat als solches ist elektrisch isolierend. Auf der einen Seite des Substrats ist eine strukturierte, die Verschaltung realisierende Kupferschicht angeordnet, auf welche die Halbleiterschalter aufgebracht sind. Auf der anderen Seite des Substrats ist meist eine weitere, oftmals unstrukturierte Kupferschicht angeordnet, die an einen Kühlkörper angrenzt. Zwischen dieser Kupferschicht und dem Kühlkörper ist oftmals eine Wärmeleitpaste angeordnet. Der Kühlkörper ist durch das Substrat von den Halbleiterschaltern elektrisch isoliert. Er kann daher groß dimensioniert werden und für die Halbleiterschalter einheitlich sein. Ein Berührschutz ist nicht erforderlich.

Eine ähnliche Vorgehensweise ist prinzipiell auch bei einem Umrichter auf Basis der Flying-Capacitor-Multileveltopologie möglich. Insbesondere durch das Substrat erhöht sich jedoch der Wärmeleitwiderstand oftmals so weit, dass die Überlastfähigkeit nicht mehr gewährleistet ist. Auch ist dieser Aufbau in Verbindung mit der Flying-Capacitor-Multileveltopologie oftmals ungeeignet für hohe Schaltfrequenzen. Gleiches gilt, wenn die Halbleiterschalter bei ansonsten unveränderter Ausgestaltung nicht auf einem Substrat, sondern auf einer Leiterplatte angeordnet sind.

Die Aufgabe der vorliegenden Erfindung besteht darin, einen Umrichter auf Basis der Flying-Capacitor-Multileveltopologie derart weiterzuentwickeln, dass er überlastfähig ist und auch bei hohen Schaltfrequenzen eingesetzt werden kann.

Die Aufgabe wird durch einen Umrichter mit den Merkmalen des Anspruchs 1 gelöst. Vorteilhafte Ausgestaltungen des Umrichters sind Gegenstand der abhängigen Ansprüche 2 bis 16.

Erfindungsgemäß wird ein Umrichter der eingangs genannten Art dadurch ausgestaltet,
- dass den Halbleiterschaltern jeweils ein eigener Kühlkörper zugeordnet ist, der eine an dem jeweiligen Halbleiterschalter direkt anliegende Kontaktfläche aufweist und mittels dessen der jeweilige Halbleiterschalter gekühlt wird, und
- dass der jeweilige Kühlkörper in einem aus einem Isoliermaterial bestehenden Gehäuse angeordnet ist, durch das der jeweilige Kühlkörper von den anderen Kühlkörpern mechanisch und elektrisch getrennt ist.

Aufgrund des direkten mechanischen Kontakts des Kühlkörpers zum jeweiligen Halbleiterschalter besteht ein sehr guter Wärmeübergang vom jeweiligen Halbleiterschalter zum jeweiligen Kühlkörper. Das Entwärmen des jeweiligen Halbleiterschalters ist daher sehr gut möglich. Somit kann die Überlastfähigkeit realisiert werden. Aufgrund des direkten mechanischen Kontakts des Kühlkörpers zum jeweiligen Halbleiterschalter besteht zwar auch eine elektrische Verbindung zwischen dem jeweiligen Halbleiterschalter und dem jeweiligen Kühlkörper. Dies ist aufgrund der mechanischen und elektrischen Trennung des jeweiligen Kühlkörpers von den anderen Kühlkörpern jedoch unkritisch.

Vorzugsweise ist der jeweilige Kühlkörper in dem Gehäuse berührsicher gehalten. Dadurch bleibt die elektrische Betriebssicherheit auch dann erhalten, wenn ein Gesamtgehäuse, in dem der Umrichter als Ganzes angeordnet ist, geöffnet wird. Die Berührsicherheit kann beispielsweise dadurch erreicht werden, dass Gehäusedurchbrüche ähnlich eines IP 20-Schutzes bestimmte Abmessungen einhalten.

Vorzugsweise weist der jeweilige Kühlkörper an seiner der Kontaktfläche gegenüberliegenden Seite eine Stützfläche auf, stützt die Stützfläche sich an dem Gehäuse an einer Lagerung ab und ist die Lagerung als domartige, federnd nachgebende Erhebung ausgebildet. Dadurch kann gewährleistet werden, dass die Kontaktfläche des jeweiligen Kühlkörpers exakt parallel oder zumindest nahezu exakt parallel zur angrenzenden Grenzfläche des jeweiligen Halbleiterschalters ausgerichtet ist (koplanare Ausrichtung). Eine etwaige Verkippung kann also vermieden werden. Dadurch kann insbesondere die gute thermische Anbindung des jeweiligen Halbleiterschalters an den jeweiligen Kühlkörper zuverlässig gewährleistet werden.

Vorzugsweise stützt die domartige, federnd nachgebende Erhebung den jeweiligen Kühlkörper an der Stützfläche im wesentlichen zentral ab. Dadurch ergibt sich eine besonders zuverlässige koplanare Ausrichtung.

Vorzugsweise ist das Gehäuse im Bereich der Stützfläche vollflächig ausgebildet. Dadurch kann die elektrische Isolierung zu dieser Seite hin besonders einfach gewährleistet werden. Bezüglich der Abgabe der Wärme an die Umgebung ist die vollflächige Ausbildung meist unkritisch, da die Abgabe der Wärme an die Umgebung durch einen Querstrom der Luft erreicht wird.

Vorzugsweise grenzen an die Kontaktfläche unmittelbar oder über eine Stufe schräge Führungsflächen an, die beim Einführen des Kühlkörpers in das Gehäuse mit korrespondierenden schrägen Führungsflächen des Gehäuses zusammenwirken. Dadurch vereinfacht sich die Montage des Umrichters.

Vorzugsweise sind die Halbleiterschalter als oberflächenmontierte Bauteile (SMD) ausgebildet. Dies bietet fertigungstechnische Vorteile, elektrische Vorteile und Größenvorteile. Weiterhin kann dadurch eine nahezu einheitliche Einbausituation (geringe Toleranzen) erreicht werden.

Die Kondensatoren können ebenfalls als oberflächenmontierte Bauteile ausgebildet sein.

Vorzugsweise weist das Gehäuse Durchbrechungen zum Zuführen von Luft zu dem jeweiligen Kühlkörper und zum Abführen von Luft von dem jeweiligen Kühlkörper auf. Dadurch eignet sich der jeweilige Kühlkörper nicht nur zum kurzzeitigen Aufnehmen einer erhöhten Verlustleistung, sondern auch zum Kühlen des jeweiligen Halbleiterschalters im Dauerbetrieb.

Die Durchbrechungen können insbesondere in Seitenflächen des Gehäuses angeordnet sein.

Vorzugsweise weist das Gehäuse, bezogen auf den jeweiligen Kühlkörper, mehrere Teile auf. Dadurch ist das Gehäuse montagefreundlich.

Beispielsweise kann ein Teil des Gehäuses an der von dem jeweiligen Halbleiterschalter abgewandten Seite des jeweiligen Kühlkörpers angeordnet sein und ein weiteres Teil an der dem jeweiligen Halbleiterschalter zugewandten Seite des jeweiligen Kühlkörpers angeordnet sein. Dadurch ist es einerseits möglich, den jeweiligen Kühlkörper an seiner von dem jeweiligen Halbleiterschalter abgewandten Seite vollflächig oder zumindest nahezu vollflächig auszubilden, so dass in diesem Bereich in elektrischer Hinsicht ein guter Schutz besteht. Dennoch ist es möglich, den Kühlkörper von dieser Seite aus in das (zu diesem Zeitpunkt noch nicht zusammengesetzte) Gehäuse einzusetzen.

Seitenflächen des Gehäuses können nach Bedarf eigenständige Teile des Gehäuses sein oder Bestandteil des einen oder des anderen der beiden vorgenannten Teile sein. Auch Mischformen sind möglich, dass beispielsweise ein Teil der Seitenflächen an dem einen der beiden vorgenannten Teile angeordnet ist und ein weiterer Teil der Seitenflächen an dem anderen der beiden vorgenannten Teile angeordnet ist.

Eine derzeit besonders bevorzugte Konstruktion besteht darin,
- dass der Umrichter eine Bodenplatte mit einer Oberseite aufweist, von der orthogonal stiftartige Abstandhalter abstehen,
- dass mindestens einer der Kühlkörper auf der Oberseite der Bodenplatte angeordnet ist, wobei zwischen der Oberseite der Bodenplatte und dem Kühlkörper eine Unterseite des Gehäuses angeordnet ist,
- dass auf den Kühlkörper an der von der Bodenplatte abgewandten Seite eine Leiterplatte aufgesetzt ist, die auf ihrer dem Kühlkörper zugewandten Seite im Bereich des Kühlkörpers den mittels des jeweiligen Kühlkörpers gekühlten Halbleiterschalter trägt, und
- dass Halteelemente mit den Abstandhaltern verbunden sind, die an der von dem Kühlkörper abgewandten Seite an der Leiterplatte anliegen und über die Leiterplatte den Halbleiterschalter an den Kühlkörper andrücken.

Diese Ausgestaltung ist einfach, robust und arbeitet zuverlässig.

Die Bodenplatte kann nach Bedarf aus Metall bestehen (Regelfall) oder aus einem elektrisch isolierenden Material bestehen, insbesondere einem Kunststoff (Ausnahme).

Die Bodenplatte kann individuell für den jeweiligen Kühlkörper oder auch für mehrere Kühlkörper vorhanden sein. Oftmals ist sie gemeinsam für zwei Halbleiterschalter vorhanden, die gleich weit von den beiden Gleichspannungsanschlüsse entfernt sind. Gleiches gilt für den Teil des Gehäuses, der sich zwischen der Bodenplatte und dem jeweiligen Kühlkörper befindet. Auch die Leiterplatte kann gemeinsam für die beiden genannten Halbleiterschalter vorhanden sein.

Die Kondensatoren können, sofern sie auf der Leiterplatte angeordnet sind, nach Bedarf auf der dem Kühlkörper zugewandten Seite oder auf der von dem Kühlkörper abgewandten Seite der Leiterplatte angeordnet sein. In jedem Fall sind sie aber derart angeordnet, dass sie von dem Kühlkörper beabstandet sind.

Vorzugsweise weist das Gehäuse mit den Abstandhaltern zusammenwirkende Führungshilfen auf, die auf die Abstandhalter aufgesetzt sind und durch welche das Gehäuse in einer durch die Oberseite der Bodenplatte definierten Ebene gesehen fixiert ist. Auch dadurch vereinfacht sich die Montage.

Vorzugsweise weisen die Halteelemente einen ersten und einen zweiten Schenkel auf, so dass die Halteelemente L-förmig ausgebildet sind. In diesem Fall liegt der jeweilige erste Schenkel an der Leiterplatte an und ist der jeweilige zweite Schenkel mit einem der Abstandhalter verbunden. Durch diese Ausgestaltung kann insbesondere auf einfache Weise das Andrücken der Halbleiterschalter an die Kühlkörper bewirkt werden.

Vorzugsweise weist die jeweilige Leiterplatte Ausnehmungen auf, durch welche die zweiten Schenkel der Halteelemente hindurch ragen. Dadurch können Hebel- und Scherkräfte, die auf die Halteelemente wirken, klein gehalten werden.

Vorzugsweise umgreifen die zweiten Schenkel der Halteelemente die Abstandhalter. Dadurch kann die Ausrichtung der Halteelemente verbessert werden.

Vorzugsweise weisen die Abstandhalter an ihrer von der Bodenplatte abgewandten Seite Innengewinde auf und weisen die zweiten Schenkel Ausnehmungen für den Durchtritt von Befestigungsschrauben auf. In diesem Fall sind die Halteelemente mittels der Befestigungsschrauben an den Abstandhaltern befestigt. Diese Ausgestaltung ist einfach und zuverlässig.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: einen Umrichter und eine Last,
- FIG 2: einen Phasenstrang,
- FIG 3: einen Halbleiterschalter und dessen Umgebung,
- FIG 4: einen Halbleiterschalter vor dem Verbinden mit einem Kühlkörper,
- FIG 5: den Halbleiterschalter von FIG 4 nach dem Verbinden mit dem Kühlkörper,
- FIG 6: einen Schnitt durch ein Gehäuse und einen Kühlkörper,
- FIG 7: ein Modul eines Umrichters in perspektivischer Darstellung,
- FIG 8: eine Explosionsdarstellung des Moduls von FIG 7,
- FIG 9: einen perspektivischen Schnitt durch das Modul von FIG 7,
- FIG 10: eine Draufsicht auf eine Leiterplatte von einer Bodenplatte des Moduls von FIG 7 aus gesehen,
- FIG 11: eine perspektivische Darstellung einer Bodenplatte des Moduls von FIG 7 und eines Teils eines Gehäuses und
- FIG 12: den mechanisch-konstruktiven Aufbau eines Umrichters.

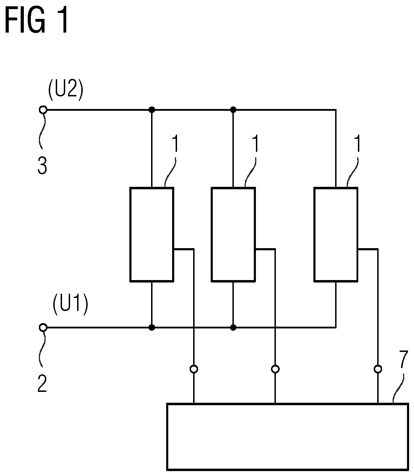

Gemäß FIG 1 weist ein Umrichter eine Mehrzahl von Phasensträngen 1 auf. Die Anzahl an Phasensträngen 1 liegt meist bei drei. Sie kann aber im Einzelfall auch bei nur zwei liegen oder größer als drei sein, insbesondere vier oder fünf betragen.

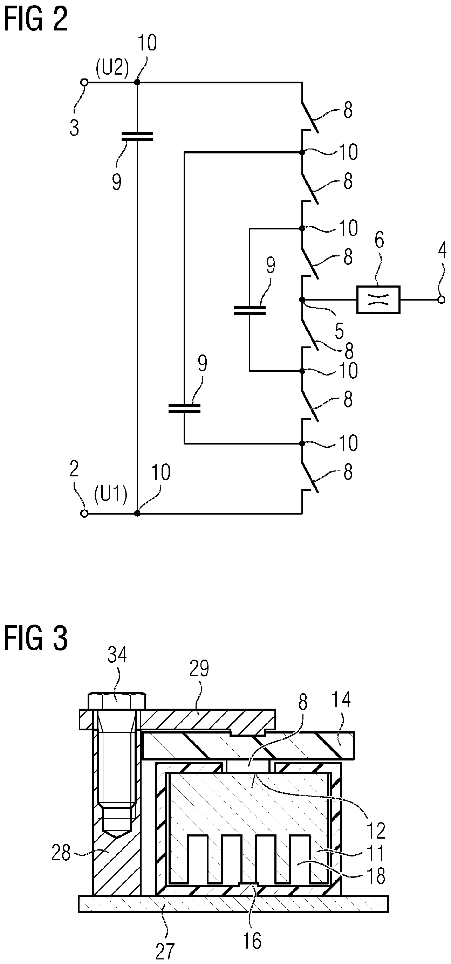

Die Phasenstränge 1 weisen gemäß FIG 2 jeweils zwei Gleichspannungsanschlüsse 2, 3 und einen Wechselspannungsanschluss 4 auf. An den Gleichspannungsanschlüssen 2, 3 stehen in aller Regel niedriges Potenzial U1 und ein hohes Potenzial U2 an. Oftmals ist der Wechselspannungsanschluss 4 mit den Gleichspannungsanschlüssen 2, 3 über einen Knotenpunkt 5 verbunden. Zwischen dem Wechselspannungsanschluss 4 und dem Knotenpunkt 5 ist meist eine Drossel 6 angeordnet.

Vorliegend wird angenommen, dass der Energiefluss von den Gleichspannungsanschlüssen 2, 3 über den Wechselspannungsanschluss 4 zu einer Last 7 (siehe FIG 1) erfolgt. Prinzipiell ist aber auch der umgekehrte Energiefluss möglich.

Die Phasenstränge 1 weisen gemäß FIG 2 zwischen dem Wechselspannungsanschluss 4 und den Gleichspannungsanschlüssen 2, 3 jeweils eine Reihenschaltung von jeweils mehreren Halbleiterschaltern 8 auf. Die Anzahl an Halbleiterschaltern 8 pro Reihenschaltung kann nach Bedarf bestimmt sein. Die Anzahl an Halbleiterschaltern 8 pro Reihenschaltung ist jedoch vom Wechselspannungsanschluss 4 aus gesehen sowohl zu dem einen als auch zu dem anderen Gleichspannungsanschluss 2, 3 hin in aller Regel gleich groß. Auch ist die Anzahl an Halbleiterschaltern 8 pro Reihenschaltung meist auch einheitlich für die Phasenstränge 1. Die in FIG 2 dargestellte Anzahl von jeweils drei Halbleiterschaltern 8 ist jedoch nur rein beispielhaft. Es könnten ebenso auch 4, 5, 6 usw. Halbleiterschalter 8 pro Reihenschaltung vorhanden sein.

Der Halbleiterschalter 8 kann ein einziges schaltendes Element aufweisen (Halbleiterschalter im engeren Sinne). Alternativ kann der Halbleiterschalter 8 mehrere elektrisch parallel zueinander angeordnete und in der Regel gleichzeitig und gleichartig geschaltete schaltende Elemente aufweisen (Halbleiterschalter im weiteren Sinne).

Die Halbleiterschalter 8 können von ihrer Funktionsweise her gesehen beispielsweise als spannungsgesteuerte Schaltelemente ausgebildet sein, beispielsweise auf IGBT-Basis oder auf FET-Basis. Diese Ausgestaltung ist weit verbreitet, arbeitet zuverlässig und weist geringe Schaltverluste auf. Von der Halbleitertechnologie her gesehen können die Halbleiterschalter 8 insbesondere als GaN-Elemente ausgebildet sein. In vielen Fällen sind den Halbleiterschaltern 8 Freilaufdioden parallel geschaltet. Die Freilaufdioden können jeweils ein intrinsischer Bestandteil des jeweiligen Halbleiterschalters 8 sein. Alternativ kann es sich um eine eigenständige Dioden (also diskrete Bauteile) handeln. Die Freilaufdioden sind in den FIG nicht dargestellt.

Gemäß FIG 2 weist die Phasenstränge 1 Kondensatoren 9 auf. Die Kondensatoren 9 sind jeweils mit zwei Knotenpunkten 10 zwischen zwei Halbleiterschaltern 8 des jeweiligen Phasenstrangs 1 verbunden. Hierbei ist vom Wechselspannungsanschluss 4 zum jeweiligen Gleichspannungsanschluss 2, 3 gesehen die Anzahl an Halbleiterschaltern 8 zwischen dem jeweiligen Knotenpunkt 10 und dem jeweiligen Gleichspannungsanschluss 2, 3 gleich groß.

FIG 3 zeigt einen einzelnen Halbleiterschalter 8 und vor allem die Art und Weise, wie dieser Halbleiterschalter 8 gekühlt wird. Gemäß FIG 3 ist dem Halbleiterschalter 8 ein Kühlkörper 11 zugeordnet, mittels dessen der in FIG 3 dargestellte Halbleiterschalter 8 gekühlt wird. Der Kühlkörper 11 weist eine Kontaktfläche 12 auf. Der Kühlkörper 11 liegt mit der Kontaktfläche 12 direkt an dem jeweiligen Halbleiterschalter 8 an. Es ist zwar möglich, dass zwischen den Halbleiterschalter 8 und den Kühlkörper 11 eine (dünne) Schicht einer Wärmeleitpaste eingebracht ist. Dies ist in der Regel jedoch nicht erforderlich. Vor allem aber erfolgt durch den direkten Kontakt eine galvanische Verbindung des Kühlkörpers 11 mit dem Halbleiterschalter 8. Der Kühlkörper 11 liegt also auf dem Potenzial des Halbleiterschalters 8. Zur elektrischen Isolierung ist der Kühlkörper 11 daher in einem Gehäuse 13 angeordnet. Das Gehäuse 13 besteht aus einem Isoliermaterial, in der Regel Kunststoff. Durch das Gehäuse 13 ist der Kühlkörper 11 von den anderen Kühlkörpern 11 mechanisch und elektrisch getrennt.

Der Kühlkörper 11 ist dem Halbleiterschalter 8 proprietär zugeordnet. Der Begriff "proprietär" ist in dem Sinne zu verstehen, dass der in FIG 3 dargestellte Kühlkörper 11 zwar den in FIG 3 dargestellten Halbleiterschalter 8 kühlt und eventuell auch weitere Halbleiterschalter 8 kühlt, aber keine anderen Halbleiterschalter 8.

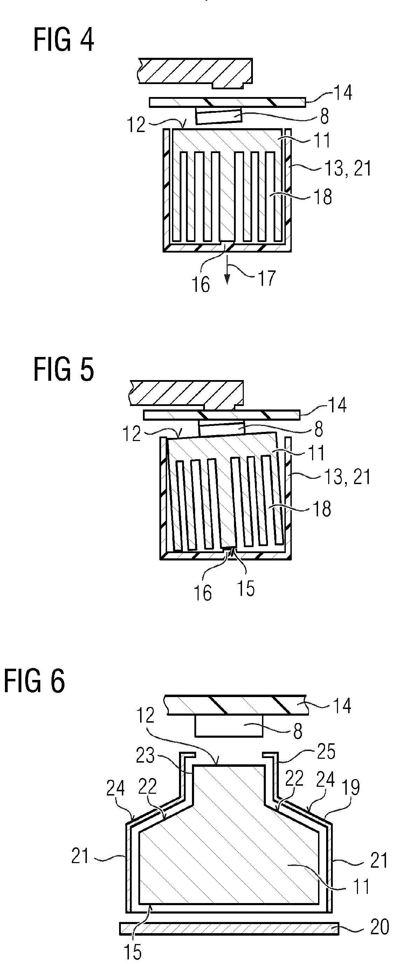

Wie bereits aus FIG 3 ersichtlich ist und noch deutlicher aus den FIG 4 und 5 hervorgeht, ist der Halbleiterschalter 8 auf einer Leiterplatte 14 angeordnet, und zwar auf der dem Kühlkörper 11 zugewandten Seite der Leiterplatte 14. Der Halbleiterschalter 8 kann entsprechend der Darstellung in den FIG 3 bis 5 insbesondere als oberflächenmontiertes Bauteil (SMD) ausgebildet sein.

Gemäß den FIG 3 bis 5 weist der Kühlkörper 11 an seiner der Kontaktfläche 12 gegenüberliegenden Seite eine Stützfläche 15 auf. Die Stützfläche 15 kann alternativ durchgehend sein oder entsprechend der Darstellung in den FIG 3 bis 5 in Kühlrippen unterteilt sein. Unabhängig davon, ob die eine oder die andere Ausgestaltung ergriffen ist, stützt sich die Stützfläche 15 an dem Gehäuse 13 an einer Lagerung 16 ab. Die Lagerung 16 ist domartig ausgebildet, das heißt dass sie gegenüber ihrer Umgebung erhöht (erhaben) ist. Es handelt sich also um eine Erhebung. Weiterhin ist die Lagerung 16, wie in FIG 4 durch einen Pfeil 17 angedeutet ist, federnd nachgiebig ausgebildet. Meist stützt die Lagerung 16 den Kühlkörper 11 an der Stützfläche 15 im wesentlichen zentral ab.

Die mehr oder minder punktuelle Abstützung an der Lagerung 16 (Erhebung) in Verbindung mit der federnd nachgiebigen Ausbildung hat zur Folge, dass die Kontaktfläche 12 des Kühlkörpers 11 stets flächig an dem Halbleiterschalter 8 anliegt. Dies gilt auch dann, wenn die dem Kühlkörper 11 zugewandte Abschlussfläche des Halbleiterschalters 8 entsprechend der Darstellung in FIG 4 vor dem Verbinden mit dem Kühlkörper 11 mit der Kontaktfläche 12 einen Winkel bildet (in FIG 4 aus Gründen der deutlicheren Darstellung stark übertrieben dargestellt). Denn aufgrund der nur punktuellen Lagerung in Verbindung mit der federnden Nachgiebigkeit können sich derartige Toleranzen bei der Montage ausgleichen.

Aus den FIG 3 bis 5 ist auch ersichtlich, dass das Gehäuse 13 im Bereich der Stützfläche 15 vollflächig ausgebildet ist. Das Gehäuse 13 weist also in diesem Bereich keine Durchbrechungen auf. Im Bereich der Kontaktfläche 12 kann das Gehäuse 13 seitlich neben der Kontaktfläche 12 alternativ im wesentlichen geschlossen sein (FIG 3) oder offen sein (FIG 4, FIG 5). Im Bereich der Seitenflächen, also zwischen der Kontaktfläche 12 und der Stützfläche 15 weist das Gehäuse 13 jedoch Durchbrechungen 18 auf. Dadurch ist es möglich, dem Kühlkörper 11 Luft zuzuführen und Luft vom Kühlkörper 11 abzuführen. Die Durchbrechungen 18 können vollflächig sein. Alternativ können die Seitenflächen relativ kleine, ein Gitter bildende Durchbrechungen aufweisen. In diesem Fall ist der Kühlkörper 11 in dem Gehäuse 13 berührsicher gehalten.

Vorzugsweise weist das Gehäuse 13, bezogen auf den jeweiligen Kühlkörper 11, mehrere Teile 19, 20 auf. Beispielsweise kann das Gehäuse 13 entsprechend der Darstellung in FIG 6 ein Teil 19 und ein Teil 20 aufweisen. Das Teil 19 kann in diesem Fall an der dem jeweiligen Halbleiterschalter 8 zugewandten Seite des jeweiligen Kühlkörpers 11 angeordnet sein, das Teil 20 an der von dem jeweiligen Halbleiterschalter 8 abgewandten Seite des jeweiligen Kühlkörpers 11. Seitenflächen 21 des Gehäuses 13 sind bei der Ausgestaltung gemäß FIG 6 Bestandteil des Teils 19. Sie könnten aber - zumindest in manchen Fällen - ebenso auch vollständig oder teilweise Bestandteil des Teils 20 sein.

FIG 6 zeigt noch eine weitere vorteilhafte Ausgestaltung der vorliegenden Erfindung. Konkret weist der Kühlkörper 11 gemäß FIG 6 schräge Führungsflächen 22 auf. Die Führungsflächen 22 grenzen vorliegend über eine Stufe 23 an die Kontaktfläche 12 an. Die Stufe 23 könnte auch entfallen. In diesem Fall würden die Führungsflächen 23 direkt und unmittelbar an die Kontaktfläche 12 angrenzen. Hiermit korrespondierend weist das Gehäuse 13 korrespondierende schräge Führungsflächen 24 (und wegen der Stufe 23 vorliegend auch eine Stufe 25) auf. Die Führungsflächen 23, 24 wirken beim Einführen des Kühlkörpers 11 in das Gehäuse 13 zusammen, so dass der Kühlkörper 11 im Gehäuse 13 ordnungsgemäß positioniert und ausgerichtet wird.

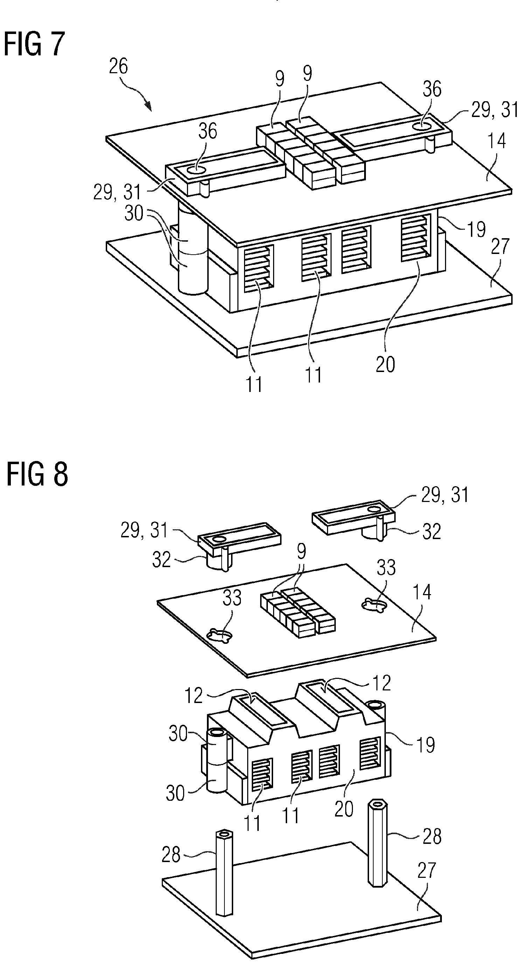

Nachfolgend wird in Verbindung mit den FIG 7 bis 11 eine mögliche konkrete Ausgestaltung eines Moduls 26 des Umrichters erläutert. Das Modul 26 ist die Montageeinheit für zwei Halbleiterschalter 8, die innerhalb der Reihenschaltungen an korrespondierenden Orten angeordnet sind. Beispielsweise kann das Modul 26 die beiden äußeren Halbleiterschalter 8 des Phasenstrangs 1 von FIG 2 umfassen, die unmittelbar an die Gleichspannungsanschluss 2, 3 angrenzen. Alternativ kann das Modul 26 die beiden inneren Halbleiterschalter 8 des Phasenstrangs 1 von FIG 2 umfassen, die unmittelbar an den Wechselspannungsanschluss 4 bzw. den Knotenpunkt 5 angrenzen. Alternativ kann das Modul 26 die beiden mittleren Halbleiterschalter 8 des Phasenstrangs 1 von FIG 2 umfassen, die zwischen den inneren und den äußeren Halbleiterschaltern 8 des Phasenstrangs 1 von FIG 2 angeordnet sind.

Gemäß den FIG 7 bis 11 weist das Modul 26 eine Bodenplatte 27 auf. Die Bodenplatte 27 weist eine Oberseite auf, von der orthogonal stiftartige Abstandhalter 28 abstehen. Mindestens einer der Kühlkörper 11 ist auf der Oberseite der Bodenplatte 27 angeordnet. Vorliegend sind die beiden Kühlkörper 11 für die beiden Halbleiterschalter 8 des Moduls 26 auf der Oberseite der Bodenplatte 27 angeordnet. Zwischen der Oberseite der Bodenplatte 27 und den Kühlkörpern 11 ist eine Unterseite des Gehäuses 13 angeordnet. Die Unterseite korrespondiert im wesentlichen mit dem Teil 20 von FIG 6. Vorliegend sind an der Unterseite teilweise auch die Seitenwände des Gehäuses 13 angeordnet.

Auf den jeweiligen Kühlkörper 11 ist an der von der Bodenplatte 27 abgewandten Seite die (vorliegend einheitliche) Leiterplatte 14 aufgesetzt, welche vorliegend die beiden Halbleiterschalter 8 des Moduls 26 trägt. Prinzipiell wäre auch eine Aufteilung der Leiterplatte 14 möglich, so dass jeder Halbleiterschalter 8 auf einer eigenen Leiterplatte 14 angeordnet ist. Unabhängig von der Aufteilung der Leiterplatte 14 sind die Halbleiterschalter 8 jedoch auf der dem Kühlkörper 11 zugewandten Seite der Leiterplatte 14 im Bereich des Kühlkörpers 11 angeordnet. Die Leiterplatte 14 trägt also die Halbleiterschalter 8 in diesem Bereich.

Die Halbleiterschalter 8 sind - ebenso wie bei den FIG 3 bis 5 - auf der dem Kühlkörper 11 zugewandten Seite der Leiterplatte 14 angeordnet. Auch die Kondensatoren 9, von denen in den FIG 7 bis 11 nur einige mit ihrem Bezugszeichen versehen sind, können auf der Leiterplatte 14 angeordnet sein. Die Bezugszeichen 9 können nach Bedarf auf der einen und/oder der anderen Seite der Leiterplatte 14 angeordnet sein.

Weiterhin weist das Modul 26 Halteelemente 29 auf. Die Halteelemente 29 sind mit den Abstandhaltern 28 verbunden. Die Halteelemente 29 liegen an der Leiterplatte 14 an, und zwar an der von den Kühlkörpern 11 abgewandten Seite der Leiterplatte 14. Über die Leiterplatte 14 drücken die Halteelemente 29 die Halbleiterschalter 8 an ihren jeweiligen Kühlkörper 11 an.

Entsprechend der Darstellung insbesondere in den FIG 7 bis 11 weist das Gehäuse 13 mit den Abstandhaltern 28 zusammenwirkende Führungshilfen 30 auf. Die Führungshilfen 30 sind auf die Abstandhalter 28 aufgesetzt. Durch die Führungshilfen 30 ist das Gehäuse 13 in einer durch die Oberseite der Bodenplatte 27 definierten Ebene gesehen seitlich fixiert.

Die Halteelemente 29 weisen einen ersten und einen zweiten Schenkel 31, 32 auf. Die Halteelemente 29 sind somit L-förmig ausgebildet. Der jeweilige erste Schenkel 31 liegt an der Leiterplatte 14 an. Der jeweilige zweite Schenkel 32 ist mit einem der Abstandhalter 28 verbunden.

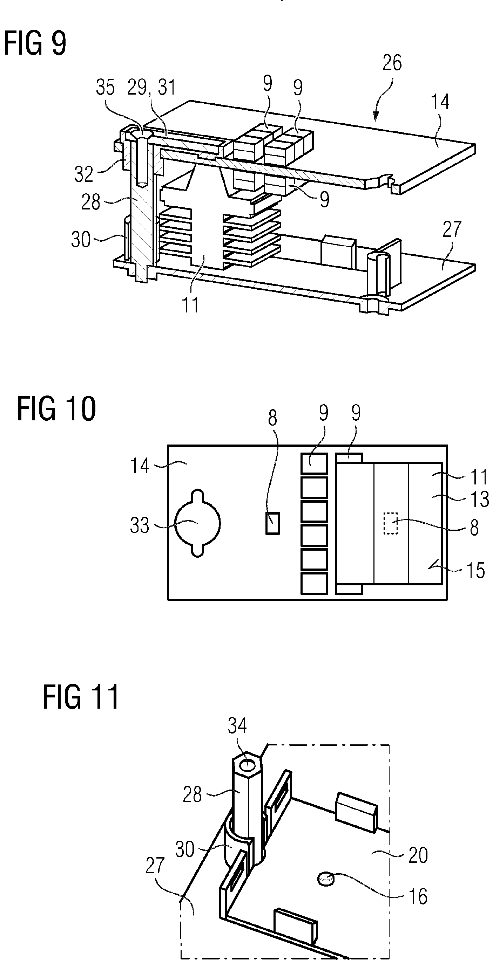

Entsprechend der Darstellung in den FIG 7 bis 11 weist die Leiterplatte 14 Ausnehmungen 33 auf. Die Ausnehmungen 33 sind - siehe insbesondere die FIG 8 und 10 - in der Ebene der Leiterplatte 14 gesehen vorzugsweise vollständig von dem Material der Leiterplatte 14 umgeben. Es handelt sich also vorzugsweise um geschlossene Ausnehmungen. Wie besonders deutlich aus den FIG 8 und 9 ersichtlich ist, ragen die zweiten Schenkel 32 der Halteelemente 29 durch die Ausnehmungen 33 hindurch. Vorzugsweise umgreifen weiterhin die zweiten Schenkel 32 der Halteelemente 29 die Abstandhalter 28.

Um die Halteelemente 29 an den Abstandhaltern 28 befestigen zu können, weisen die Abstandhalter 28 an ihrer jeweiligen von der Bodenplatte 27 abgewandten Seite ein Innengewinde 34 auf. Weiterhin weisen die zweiten Schenkel 32 Ausnehmungen 35 für den Durchtritt von Befestigungsschrauben 36 auf. Somit ist es auf einfache Weise möglich, die Halteelemente 29 mittels der Befestigungsschrauben 36 an den Abstandhaltern 28 zu befestigen.

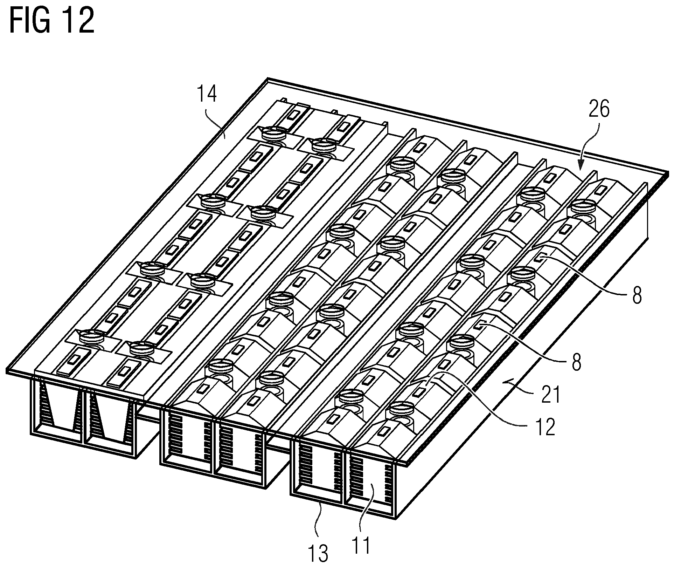

Gemäß FIG 12 weist ein Umrichter eine Vielzahl derartiger Module 26 auf. Von den Modulen 26 und auch von den Halbleiterschaltern 8 sind in FIG 12 nur einige mit ihrem Bezugszeichen versehen. Konkret bilden die Module 26 drei Doppelreihen mit jeweils acht Modulen 26. Die acht Module 26 einer jeweiligen Doppelreihe enthalten in ihren beiden Reihen die beiden Reihenschaltungen von Halbleiterschaltern 8 eines der Phasenstränge 1.

Ersichtlich sind die beiden Kühlkörper 11 eines jeweiligen Moduls 26 voneinander getrennt und sind weiterhin die Kühlkörper 11 der Module 26 voneinander aufgrund des Abstands der Module 26 voneinander ebenfalls getrennt. Die Bodenplatte 27 kann einheitlich für alle Module 26 sein. Gleiches gilt für die Unterseiten der Gehäuse 13. Die Leiterplatte 14 ist vorliegend einheitlich für alle Module 26 vorhanden. Die Gehäuse 13 nehmen jeweils die Kühlkörper 11 einer jeweiligen Doppelreihe auf.

Zusammengefasst betrifft die vorliegende Erfindung somit folgenden Sachverhalt:
Ein Umrichter weist eine Mehrzahl von Phasensträngen 1 auf, die jeweils zwei Gleichspannungsanschlüsse 2, 3, einen Wechselspannungsanschluss 4 und zwischen dem Wechselspannungsanschluss 4 und den Gleichspannungsanschlüssen 2, 3 jeweils eine Reihenschaltung von jeweils mehreren Halbleiterschaltern 8 aufweisen. Die Phasenstränge 1 weisen weiterhin Kondensatoren 9 auf, die jeweils mit zwei Knotenpunkten 10 zwischen zwei Halbleiterschaltern 8 des jeweiligen Phasenstrangs 1 verbunden sind. Vom Wechselspannungsanschluss 4 zum jeweiligen Gleichspannungsanschluss 2, 3 gesehen ist die Anzahl an Halbleiterschaltern 8 zwischen dem jeweiligen Knotenpunkt 10 und dem jeweiligen Gleichspannungsanschluss 2, 3 gleich groß. Den Halbleiterschaltern 8 ist jeweils ein eigener Kühlkörper 11 zugeordnet, der eine an dem jeweiligen Halbleiterschalter 8 direkt anliegende Kontaktfläche 12 aufweist und mittels dessen der jeweilige Halbleiterschalter 8 gekühlt wird. Der jeweilige Kühlkörper 11 ist in einem aus einem Isoliermaterial bestehenden Gehäuse 13 angeordnet, durch das der jeweilige Kühlkörper 11 von den anderen Kühlkörpern 11 mechanisch und elektrisch getrennt ist.

Die vorliegende Erfindung weist viele Vorteile auf. Durch die direkte Anbindung der Halbleiterschalter 8 an die Kühlkörper 11 ergibt sich eine ausgezeichnete thermische Anbindung der Halbleiterschalter 8 an die Kühlkörper 11, so dass die Überlastfähigkeit ohne weiteres erzielt werden kann. Der Wärmeübergang wird durch das individuelle Andrücken der Halbleiterschalter 8 an die Kühlkörper 11 noch weiter verbessert. Aufgrund der Lagerung 16 (punktuelle domartige, federnd nachgiebige Erhebung) ergibt sich bei der Montage der Module 26 ein automatischer Toleranzausgleich. Aufgrund der einzelnen, jeweils für sich gesehen relativ kleinen Kühlkörper 11 ergeben sich nur geringe elektrische Koppelkapazitäten. Das EMV-Verhalten wird dadurch verbessert. Der Umrichter kann problemlos nach Bedarf skaliert werden. Die Kühlkörper 11 können in aller Regel aus Aluminium und damit mechanisch stabil und kostengünstig hergestellt werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Umrichter,
- wobei der Umrichter eine Mehrzahl von Phasensträngen (1) aufweist,
- wobei die Phasenstränge (1) jeweils zwei Gleichspannungsanschlüsse (2, 3) und einen Wechselspannungsanschluss (4) aufweisen,
- wobei die Phasenstränge (1) zwischen dem Wechselspannungsanschluss (4) und den Gleichspannungsanschlüssen (2, 3) jeweils eine Reihenschaltung von jeweils mehreren Halbleiterschaltern (8) aufweisen,
- wobei die Phasenstränge (1) Kondensatoren (9) aufweisen, die jeweils mit zwei Knotenpunkten (10) zwischen zwei Halbleiterschaltern (8) des jeweiligen Phasenstrangs (1) verbunden sind,
- wobei vom Wechselspannungsanschluss (4) zum jeweiligen Gleichspannungsanschluss (2, 3) gesehen die Anzahl an Halbleiterschaltern (8) zwischen dem jeweiligen Knotenpunkt (10) und dem jeweiligen Gleichspannungsanschluss (2, 3) gleich groß ist,
**dadurch gekennzeichnet,**
- **dass** den Halbleiterschaltern (8) jeweils ein eigener Kühlkörper (11) zugeordnet ist, der eine an dem jeweiligen Halbleiterschalter (8) direkt anliegende Kontaktfläche (12) aufweist und mittels dessen der jeweilige Halbleiterschalter (8) gekühlt wird, und
- **dass** der jeweilige Kühlkörper (11) in einem aus einem Isoliermaterial bestehenden Gehäuse (13) angeordnet ist, durch das der jeweilige Kühlkörper (11) von den anderen Kühlkörpern (11) mechanisch und elektrisch getrennt ist.

2. Umrichter nach Anspruch 1,
**dadurch gekennzeichnet,**
**dass** der jeweilige Kühlkörper (11) in dem Gehäuse (13) berührsicher gehalten ist.

3. Umrichter nach Anspruch 1 oder 2,
**dadurch gekennzeichnet,**
**dass** der jeweilige Kühlkörper (11) an seiner der Kontaktfläche (12) gegenüberliegenden Seite eine Stützfläche (15) aufweist, dass die Stützfläche (15) sich an dem Gehäuse (13) an einer Lagerung (16) abstützt und dass die Lagerung (16) als domartige, federnd nachgebende Erhebung ausgebildet ist.

4. Umrichter nach Anspruch 3,
**dadurch gekennzeichnet,**
**dass** die domartige, federnd nachgebende Erhebung den jeweiligen Kühlkörper (11) an der Stützfläche (15) im wesentlichen zentral abstützt.

5. Umrichter nach Anspruch 3 oder 4,
**dadurch gekennzeichnet,**
**dass** das Gehäuse (13) im Bereich der Stützfläche (15) vollflächig ausgebildet ist.

6. Umrichter nach Anspruch 3, 4 oder 5,
**dadurch gekennzeichnet,**
**dass** an die Kontaktfläche (12) unmittelbar oder über eine Stufe (23) schräge Führungsflächen (22) angrenzen, die beim Einführen des Kühlkörpers (L) in das Gehäuse (13) mit korrespondierenden schrägen Führungsflächen (24) des Gehäuses (13) zusammenwirken.

7. Umrichter nach einem der obigen Ansprüche,
**dadurch gekennzeichnet,**
**dass** die Halbleiterschalter (8) als oberflächenmontierte Bauteile (SMD) ausgebildet sind.

8. Umrichter nach einem der obigen Ansprüche,
**dadurch gekennzeichnet,**
**dass** das Gehäuse (13) Durchbrechungen (18) zum Zuführen von Luft zu dem jeweiligen Kühlkörper (L) und zum Abführen von Luft von dem jeweiligen Kühlkörper (L) aufweist.

9. Umrichter nach einem der obigen Ansprüche,
**dadurch gekennzeichnet,**
**dass** das Gehäuse (13), bezogen auf den jeweiligen Kühlkörper (11), mehrere Teile (19, 20) aufweist.

10. Umrichter nach Anspruch 9,
**dadurch gekennzeichnet,**
**dass** ein Teil (20) des Gehäuses an der von dem jeweiligen Halbleiterschalter (8) abgewandten Seite des jeweiligen Kühlkörpers (11) angeordnet ist und dass ein weiteres Teil (19) an der dem jeweiligen Halbleiterschalter (8) zugewandten Seite des jeweiligen Kühlkörpers (11) angeordnet ist.

11. Umrichter nach einem der obigen Ansprüche,
**dadurch gekennzeichnet,**
- **dass** der Umrichter eine Bodenplatte (27) mit einer Oberseite aufweist, von der orthogonal stiftartige Abstandhalter (28) abstehen,
- **dass** mindestens einer der Kühlkörper (11) auf der Oberseite der Bodenplatte (27) angeordnet ist, wobei zwischen der Oberseite der Bodenplatte (27) und dem Kühlkörper (11) eine Unterseite des Gehäuses (13) angeordnet ist,
- **dass** auf den Kühlkörper (L) an der von der Bodenplatte (27) abgewandten Seite eine Leiterplatte (14) aufgesetzt ist, die auf ihrer dem Kühlkörper (11) zugewandten Seite im Bereich des Kühlkörpers (11) den mittels des jeweiligen Kühlkörpers (11) gekühlten Halbleiterschalter (8) trägt, und
- **dass** Halteelemente (29) mit den Abstandhaltern (28) verbunden sind, die an der von dem Kühlkörper (11) abgewandten Seite an der Leiterplatte (14) anliegen und über die Leiterplatte (14) den Halbleiterschalter (8) an den Kühlkörper (11) andrücken.

12. Umrichter nach Anspruch 11,
**dadurch gekennzeichnet,**
**dass** das Gehäuse (13) mit den Abstandhaltern (28) zusammenwirkende Führungshilfen (30) aufweist, die auf die Abstandhalter (28) aufgesetzt sind und durch welche das Gehäuse (13) in einer durch die Oberseite der Bodenplatte (27) definierten Ebene gesehen fixiert ist.

13. Umrichter nach Anspruch 11 oder 12,
**dadurch gekennzeichnet,**
**dass** die Halteelemente (29) einen ersten und einen zweiten Schenkel (31, 32) aufweisen, so dass die Halteelemente (29) L-förmig ausgebildet sind, dass der jeweilige erste Schenkel (31) an der Leiterplatte (14) anliegt und dass der jeweilige zweite Schenkel (32) mit einem der Abstandhalter (28) verbunden ist.

14. Umrichter nach Anspruch 13,
**dadurch gekennzeichnet,**
**dass** die jeweilige Leiterplatte (14) Ausnehmungen (33) aufweist, durch welche die zweiten Schenkel (32) der Halteelemente (29) hindurch ragen.

15. Umrichter nach Anspruch 13 oder 14,
**dadurch gekennzeichnet,**
**dass** die zweiten Schenkel (32) der Halteelemente (29) die Abstandhalter (28) umgreifen.

16. Umrichter nach Anspruch 13, 14 oder 15,
**dadurch gekennzeichnet,**
**dass** die Abstandhalter (28) an ihrer von der Bodenplatte (27) abgewandten Seite Innengewinde (34) aufweisen, dass die zweiten Schenkel (32) Ausnehmungen (35) für den Durchtritt von Befestigungsschrauben (36) aufweisen und dass die Halteelemente (29) mittels der Befestigungsschrauben (36) an den Abstandhaltern (28) befestigt sind.
